# FASCICULE DE BREVET EUROPEEN

(11) **EP 0 597 753 B1**
(45) Date de publication et mention de la délivrance du brevet: **27.11.1996**
(21) Numéro de dépôt: 93402680.8
(22) Date de dépôt: 29.10.1993
(51) Int. Cl.: G09F 9/00, G06K 11/12, H03K 17/955

(54) **Terminal de communication compact et ergonomique muni de surfaces de détection de proximité**
Kompaktes, ergonomisches Kommunikationsendgerät, ausgestattet mit Flächen zur Näherungsdetektion
Compact, ergonomic communication terminal equipped with proximity detecting surfaces

(30) Priorité: 12.11.1992 FR 9213798
(43) Date de publication de la demande: 18.05.1994
(73) Titulaire: SEXTANT AVIONIQUE, F-92366 Meudon la Forêt Cédex (FR)
(72) Inventeur: Debrus, Marie-Hélène, F-92100 Boulogne Billancourt (FR); Gaultier, Philippe, F-78150 Le Chesnay (FR); Vouillon, Patrick, F-91140 Villebon sur Yvette (FR)
(74) Mandataire: de Saint-Palais, Arnaud Marie

(56) Documents cités:
- EP-A- 0 474 232
- EP-A- 0 490 712
- US-A- 4 566 001

## Description

La présente invention concerne un terminal de communication particulièrement adapté pour assurer des communications homme/machine notamment, mais non exclusivement, à l'intérieur du poste de pilotage d'un aéronef.

Dans ce contexte, il est connu d'utiliser des terminaux comportant un écran de visualisation intégré à un organe de commande.

Cet organe de commande se présente soit sous la forme d'un clavier muni de touches intégré au terminal, soit sous la forme d'une surface tactile transparente disposée contre l'écran.

Sous la forme d'un clavier, l'organe de commande présente l'inconvénient d'obliger l'opérateur à déplacer son champ visuel continuellement entre l'écran et le clavier. En outre, ce type d'organes de commande ne permet pas aisément la désignation d'une zone de l'écran, ou le déplacement d'un objet affiché à l'écran.

Sous la forme d'une surface tactile transparente, l'organe de commande permet de supprimer les inconvénients du clavier mais est inutilisable avec un écran de petites dimensions spécialement dans le contexte du poste de pilotage d'un aéronef. En effet, lorsque l'opérateur pose son doigt sur cette surface, par exemple pour activer une commande, il masque une bonne partie de l'écran avec sa main.

En outre, l'application de doigts sur cette surface laisse inévitablement des traces qui, à la longue, affectent la visibilité de l'écran.

Par ailleurs, une surface tactile sur un écran ne permet pas de renvoyer à l'utilisateur la confirmation de son action par sensation mécanique de rupture d'effort.

Pour ces raisons, l'utilisation d'une surface tactile transparente placée devant l'écran est difficilement envisageable dans le contexte de l'aviation où les consignes de sécurité sont très contraignantes.

D'autre part, les applications aéronautiques modernes nécessitent l'utilisation d'une surface de visualisation de plus en plus grande, la dimension de cette surface étant limitée par la place disponible dans un cockpit.

La présente invention a particulièrement pour but de supprimer ces inconvénients en augmentant au maximum le volume de l'écran par rapport à celui occupé par le clavier, sans pour autant limiter les fonctionnalités et l'ergonomie de ce dernier. Elle propose, à cet effet, un terminal de communication homme/machine comprenant un écran de visualisation et des moyens de commande répartis à la périphérie de l'écran et comprenant deux dispositifs de détection effectuant chacun la détection sur un axe respectif, de la position d'un objet utilisé comme instrument de dialogue, les axes de ces deux dispositifs étant perpendiculaires et disposés chacun en regard d'un bord de l'écran.

Cette configuration permet, par exemple, de désigner n'importe quel point de l'écran. En effet, le positionnement de l'objet, par exemple, d'un doigt d'un opérateur sur chaque axe perpendiculaire permet de désigner respectivement deux lignes perpendiculaires de l'écran et donc, le point d'intersection de ces deux lignes.

Elle permet également de commander l'incrémentation ou la décrémentation d'une variable affichée à l'écran en déplaçant le doigt le long d'un axe de détection.

En plus du mode de fonctionnement précédemment exposé, ces deux dispositifs présentent un second mode de fonctionnement selon lequel chacun des deux axes de détection est divisé en une pluralité de segments constituant chacun une zone de commutation assimilable à une touche d'actionnement d'un interrupteur.
Ce second mode de fonctionnement permet, par exemple, la validation ou l'activation de commandes éventuellement définies à l'écran, le passage d'un mode à l'autre s'effectuant par une action de l'opérateur sur les dispositifs de détection.

Un tel terminal a été décrit dans la demande de brevet français No 90 15597 (EP-A-0 490 712), déposée au nom de la Demanderesse. Cependant ce terminal présente l'inconvénient de ne pas pouvoir être manipulé facilement, et notamment, utilisé en "aveugle".

Pour améliorer l'ergonomie du dispositif selon l'invention, chacun de ces segments de commutation est associé à des moyens de guidage du doigt le long de leurs axes respectifs, et des moyens de centrage du doigt sur chaque segment de commutation. Ces moyens de guidage consistent en des bords en relief qui s'étendent parallèlement et de part et d'autre des axes de détection, en délimitant ainsi une zone de détection longitudinale pour chaque dispositif de détection, tandis que les moyens de centrage consistent en des échancrures ménagées dans les susdits bords, et délimitent chacun un segment de commutation.

Grâce à de tels dispositifs de détection, le terminal selon l'invention présente de nombreux avantages notamment du point de vue encombrement et ergonomie. Avec une électronique de gestion adaptée, il offre simultanément les fonctionnalités d'un clavier et d'une surface tactile dans un volume à peine supérieur à celui des écrans plats disponibles à l'heure actuelle.

Selon un premier mode d'exécution, ces dispositifs de détection sont constitués d'une pluralité d'interrupteurs à double mode de fonctionnement tels que décrits dans la demande de brevet français No 90 15597, déposée au nom de la Demanderesse. Ces interrupteurs alignés sur l'axe de détection, comprennent des éléments de contact actionnables sous l'effet d'une pression et utilisés pour effectuer une détection, par effet capacitif de la proximité d'un objet.

On rappelle que dans un système de ce genre, la précision dans la détermination de la position d'un objet peut être rendue indépendante du nombre d'interrupteurs. Pour cela, il suffit que le logiciel de gestion du terminal effectue un calcul de moyenne pondérée par des coefficients représentatifs du niveau d'influence de chaque interrupteur.

Selon un autre mode de réalisation de l'invention, ces dispositifs de détection utilisent le principe de détection par ondes acoustiques se propageant dans une lame de verre.

Un dispositif de ce type a par exemple été décrit dans la demande de brevet européen publié sous le numéro 0 474 232. Toutefois, ce dispositif consiste à détecter et localiser les vibrations engendrées par l'application du doigt sur la lame de verre, ce qui limite les possibilités de commande et rend difficile la gestion et la commande du dispositif dans lesdits deux modes de fonctionnement.

Pour supprimer ces inconvénients, l'invention exploite le phénomène d'atténuation produite sur les ondes acoustiques se propageant dans la lame de verre à proximité d'un objet exerçant une pression sur celle-ci, l'atténuation produite étant fonction de la pression exercée par l'objet.

Cette dernière caractéristique permet de reproduire le comportement d'un interrupteur lorsque la pression exercée dépasse un certain seuil.

Un mode de réalisation du terminal selon l'invention sera décrit ci-après, à titre d'exemple non limitatif, avec référence aux dessins annexés dans lesquels :
La figure 1 représente schématiquement le terminal de communication ;
La figure 2 est une coupe longitudinale schématique montrant la structure mécanique d'une bande de détection de proximité selon un premier mode de réalisation ;
La figure 3 est un schéma de principe d'un circuit électronique pouvant être associé à un interrupteur du type de ceux représentés figure 2 ;
La figure 4 représente schématiquement une vue de dessus d'une bande de détection de proximité selon un second mode de réalisation ;
La figure 5 est une coupe transversale de la bande de détection de proximité représentée figure 4.

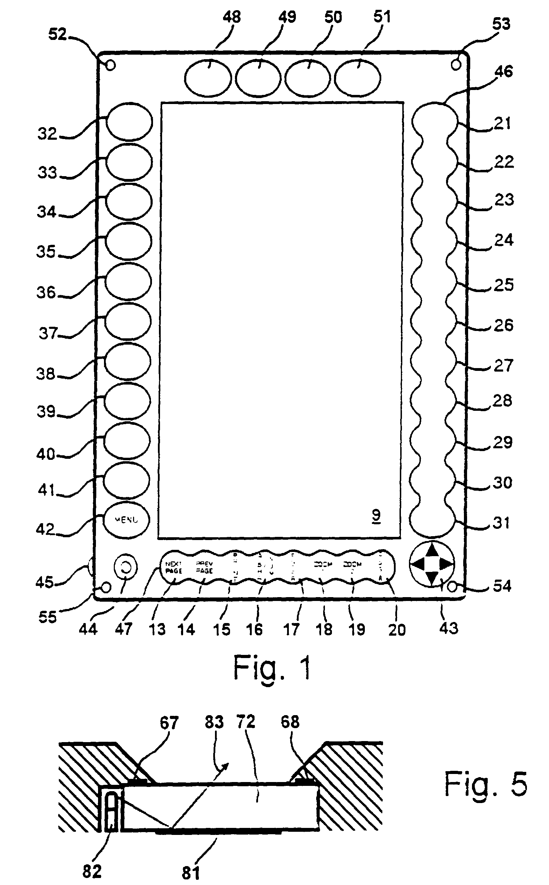

Le terminal de communication représenté sur la figure 1 comporte un écran de visualisation 9 plat et rectangulaire et un organe de dialogue disposé autour de l'écran 9 respectivement le long des bords droits et inférieurs de l'écran.

Il présente une forme parallélépipédique de dimensions légèrement supérieures à celles de l'écran de visualisation 9.

L'écran est, par exemple, de type à cristaux liquides couleur à haute résolution. Ses dimensions sont de l'ordre de 15 cm par 20 cm, soit 25 cm de diagonale. Il est protégé par une vitre anti-reflet multicouches et est éclairé par derrière par un module d'éclairage composé de tubes fluorescents de haute luminescence et de faible diamètre (4 à 6 mm).

L'électronique de commande du terminal est répartie autour de l'écran et du module d'éclairage de manière à ce que le terminal soit d'épaisseur réduite.

L'organe de dialogue comprend :
- une première bande de détection de proximité 46 à double mode de fonctionnement s'étendant le long du bord droit de l'écran 9, et divisé en onze segments de commutation 21 à 31 ;
- une deuxième bande de détection de proximité 47 à double mode de fonctionnement s'étendant le long du bord inférieur de l'écran 9 et divisé en huit segments de commutation 13 à 20 ;
- quatre touches 48 à 51 disposées le long du bord supérieur de l'écran ;
- onze touches 32 à 42 disposées le long du bord gauche de l'écran ;
- une touche de déplacement 43, située dans le coin inférieur droit de l'écran 9 représentant quatre flèches orientées dans les quatre sens permettant de commander le déplacement d'un objet affiché à l'écran ;
- une molette 44 située dans le coin inférieur gauche pour mettre le terminal sous ou hors tension et régler l'intensité d'éclairement de l'écran.

Chacune des bandes de détection de proximité 46, 47 est délimitée par des bordures en relief de manière à constituer une gouttière présentant un profil en U et permettant de guider le doigt le long de son axe de détection. Ces bordures présentent un crantage formant une échancrure de part et d'autre de chaque segment de commutation de manière à faciliter le centrage du doigt sur les zones de commutation.

Certains organes de commutation présentent une légende, comme c'est le cas des segments 13 à 20, et de la touche 42 intitulée "MENU" située dans le coin inférieur gauche de l'écran. Ces légendes indiquent la fonction activée lorsque l'organe de commutation est actionné. Les segments 13 à 20 permettent d'activer les fonctions liées à la gestion du terminal, à savoir en partant de la gauche :
- "NEXT PAGE" (13) qui provoque l'affichage de la page suivante,
- "PREV. PAGE" (14) qui provoque l'affichage de la page précédente,
- "PRINT" (15) qui permet de lancer l'impression de l'écran,
- "ALPHA/NUM" (16) qui permet de passer d'un mode de saisie alphabétique à un mode de saisie numérique et réciproquement,
- "ENTER" (17) qui permet de valider une saisie,
- "ZOOM 1" (18) et "ZOOM 2" (19) qui permettent d'agrandir la page présente à l'écran selon respectivement, deux facteurs d'échelle et réciproquement, et
- "CURSOR" (20) qui permet d'afficher un curseur.

La touche 42 intitulée "MENU" permet d'afficher le dernier menu qui a permis d'accéder à la page affichée à l'écran 9.

L'organe de dialogue comprend également un circuit imprimé, découpé et positionné autour de l'écran, qui supporte les touches 32 à 43 et 48 à 51 et les bandes de détection de proximité 46, 47. Il supporte également un dispositif d'éclairage nocturne des légendes des organes de commutation commandé par une molette 45 située à proximité du coin inférieur gauche du terminal sur sa tranche.

L'électronique de gestion du terminal comprend :
- un module de gestion de l'organe de dialogue,
- un module de gestion des entrées/sorties lui permettant de communiquer avec des organes externes,
- un module de gestion de l'éclairage de l'écran,
- un module de réglage de l'intensité d'éclairage des touches et des bandes de détection de proximité, et
- un module de ventilation forcée.

Le module de gestion de l'éclairage de l'écran est couplé, d'une part, à la molette de réglage 44 et, d'autre part, à quatre photodiodes 52 à 55 placées aux quatre coins du terminal mesurant l'éclairement de l'environnement du terminal.

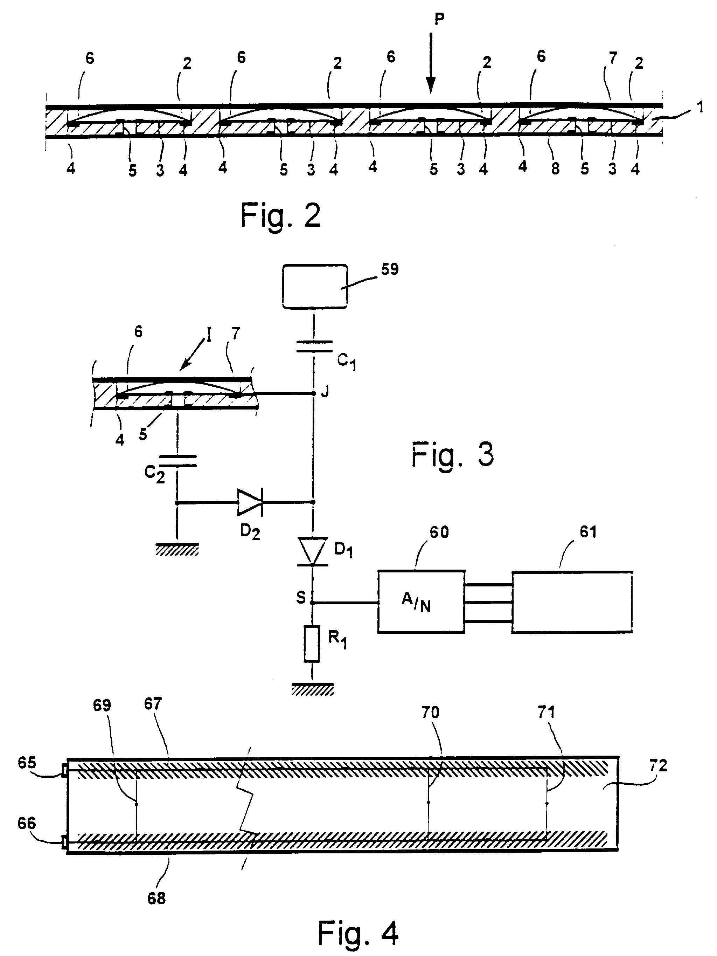

Dans l'exemple représenté figure 2, chaque bande de détection de proximité se compose tout d'abord d'un substrat plat 1, consistant par exemple en une plaquette de circuit imprimé, muni d'une pluralité de cavités cylindriques 2 (lamages) servant chacune de logement à un interrupteur respectif.

Le fond 3 de chacune de ces cavités 2 est muni d'une métallisation annulaire 4 de diamètre extérieur sensiblement égal au diamètre de la cavité 2, ainsi que d'une métallisation centrale 5 qui sert d'élément de contact fixe.

A l'intérieur de chacune des cavités 2 est disposée une capsule métallique 6, élastiquement déformable, en forme de calotte, dont la base circulaire présente un diamètre sensiblement égal au diamètre de la cavité 2. De ce fait, cette capsule 6 vient porter par sa base sur la métallisation annulaire 4, tandis que sa partie centrale s'étend au-dessus de la métallisation centrale 5.

Les capsules 6 sont maintenues à l'intérieur des évidements grâce à un film 7 en matière plastique élastiquement déformable qui vient recouvrir la face supérieure du substrat 1 et est fixé sur celui-ci, par exemple, par collage.

Avantageusement, la face intérieure du substrat 1 porte un circuit électronique électriquement connecté aux métallisations annulaires 4 et aux métallisations centrales 5 (figure 3).

Il est clair qu'au repos, la partie centrale de chaque capsule 6 est écartée de la métallisation centrale 5. L'interrupteur formé par ces deux éléments est alors en position ouverte.

A partir de cette position, une pression P exercée sur le sommet de la capsule 6 va provoquer une déformation élastique de la capsule 6 qui, après une inversion de concavité (effet tactile), vient porter sur la métallisation centrale 5. L'interrupteur est alors fermé.

Pour pouvoir effectuer une détection de proximité, il suffit de relier chaque métallisation 4 et 5 à un circuit de mesure de capacité.

Ce circuit est alimenté par un générateur 59 délivrant un signal périodique haute fréquence (figure 3). Ce signal est appliqué, par l'intermédiaire d'un condensateur C1, d'une part, à la métallisation annulaire 4 de l'interrupteur I et, d'autre part, à l'anode d'une diode D1 et à la cathode d'une diode D2 dont l'anode est à la masse. La métallisation centrale 5 de l'interrupteur I est, quant à elle, reliée à la masse par l'intermédiaire d'un condensateur C2 présentant une capacité relativement élevée.

La cathode de la diode D1, correspondant au point S où est relevé le niveau de tension représentatif de l'état de l'interrupteur I, est reliée à la masse par l'intermédiaire d'une résistance R1.

Lorsque l'interrupteur I est à l'état ouvert et en l'absence d'élément conducteur à proximité de la capsule 6, le signal appliqué par le générateur 59 est redressé et filtré. On obtient au point S un premier niveau de tension.

La présence d'un corps électriquement conducteur, par exemple, un doigt d'un opérateur, à proximité de la capsule 6 a pour effet d'introduire une capacité parasite entre le point S et la masse. En conséquence, il s'établit un courant de fuite qui atténue la tension en S et qui produit donc un deuxième niveau de tension bien inférieur au premier.

Dans le cas où l'interrupteur I est fermé, le générateur est mis à la masse par l'intermédiaire des condensateurs C1 et C2. Si la capacité du condensateur C2 est suffisamment élevée, la tension au point S est très faible, voire nulle.

Pour déterminer l'état de l'interrupteur I, il suffit donc d'analyser la tension du signal prélevé au point S.

Bien entendu, cette opération peut s'effectuer par un système analogique (qui procède par exemple par comparaison de la tension avec des seuils), de manière à discerner les trois niveaux de tension.

Elle peut être également effectuée tout simplement par un circuit numérique comprenant un convertisseur analogique/numérique 60 dont l'entrée est reliée au point S et dont la sortie est traitée par un circuit 61 qui fait partie du module de gestion de l'organe de dialogue.

Ce circuit 61 mesure précisément le niveau de tension au point S et effectue un traitement logiciel permettant de discriminer la situation de chaque interrupteur qui peut être :
- soit non influencé ; dans ce cas, aucune action est déclenchée,
- soit fermé ; l'ordre d'activation de la commande associée à l'interrupteur est alors envoyé au module de gestion du terminal,
- soit influencé par la proximité d'un doigt ; un coefficient représentatif de l'importance de cette influence est alors numérisé puis mémorisé pour déterminer précisément la position du doigt par un calcul de moyenne pondérée.

Dans ce dernier cas, si un seul interrupteur est influencé, le doigt est situé sur l'interrupteur. Par contre, si deux interrupteurs sont influencés, le doigt se trouve entre les deux. Le module de gestion de l'organe de dialogue calcule alors la moyenne pondérée par les coefficients associés aux deux interrupteurs et détermine ainsi la position du doigt sur l'axe de détection par rapport à une origine fixe. Avec un calcul numérique sur dix bits, on obtient une résolution de mille vingt-quatre points par bande de détection. De cette manière, la position du doigt est déterminée avec une précision indépendante du nombre d'interrupteurs appartenant à la bande à condition que la distance entre le centre de chaque interrupteur soit limitée (pour que deux touches à la fois puissent être influencées).

En outre, la sensibilité des bandes de détection 46, 47 est fixée par des seuils qui tiennent compte des influences parasites (température, bruit des signaux analogiques, ...). Elle est réglée pour admettre une utilisation avec ou sans gants.

Pour pouvoir détecter un mouvement du doigt sur chacune de ces bandes 46, 47, le cycle de scrutation est suffisamment rapide pour pouvoir mesurer la position du doigt sur son axe et la transmettre sans arrêt au gestionnaire du terminal. De cette manière, il est possible de reconstituer le mouvement du doigt sur l'axe de la bande et de le prendre immédiatement en compte.

Ces bandes de détection de proximité, disposées le long des bords de l'écran, offrent de nombreuses possibilités.

Elles permettent notamment :
- de désigner n'importe quel point de l'écran par désignation d'un point de chacune des deux bandes de détection ; la désignation d'un point d'une bande de détection permettant de désigner une ligne perpendiculaire à l'axe de détection ;
- de commander l'incrémentation ou la décrémentation d'une variable à partir de l'amplitude du déplacement du doigt sur un axe de détection et de son sens ;
- de commander le déplacement d'un curseur ou d'une image ;
- la gestion d'un menu ;
- ou encore, de commander le déplacement d'une aire de visualisation à l'intérieur d'un livre, la bande verticale 46 permettant de déplacer la zone de la page affichée à l'écran, et la bande horizontale 47 permettant de tourner les pages.

Dans le cas de la gestion des menus, il est possible de présenter les menus sur plusieurs colonnes, ce qui permet de proposer un grand nombre de choix possibles. La bande horizontale 47 permet alors de sélectionner une colonne, tandis que la bande verticale 46 permet de sélectionner une ligne.

Dans le cas où une image affichée à l'écran est plus grande que celui-ci, l'association de telles bandes 46,47 à la touche de commande 43 de déplacement d'un curseur permet à la fois de déplacer le curseur sur l'écran pour désigner un objet de l'image, et de déplacer l'image par rapport à l'écran pour visualiser une autre partie de l'image.

L'assignation d'une fonction à ces bandes sensitives est avantageusement effectuée en fonction de l'application en cours sur le terminal.

Un tel terminal, ayant un encombrement à peine supérieur à celui d'un écran plat, offre donc un grand confort d'utilisation.

Selon un autre mode de réalisation, les bandes de détection de proximité 46,47 mettent en oeuvre le principe de détection monoaxe par ondes acoustiques internes se propageant dans une lame de verre.

Selon le schéma présenté figure 4, des ondes acoustiques sont émises par un transducteur d'émission 65, à une extrémité de la bande de détection de proximité, dans la masse d'une lame de verre 72 d'au moins 1 mm d'épaisseur et formant la bande de détection. Grâce à un premier ensemble de réflecteurs 67, disposés à 45 degrés par rapport à l'axe longitudinal de la bande, sur le trajet des ondes acoustiques émises par le transducteur 65, les ondes acoustiques se réfléchissent dans une direction perpendiculaire en suivant une multiplicité de trajets de longueurs différentes, répartis sur toute la surface de la lame de verre, par exemple 59, 70, 71, vers un deuxième ensemble de réflecteurs 68.

Les réflecteurs du deuxième ensemble 68 sont également disposés à 45 degrés par rapport à la direction des ondes acoustiques incidentes et permettent d'envoyer les ondes acoustiques dans une direction opposée à celle d'émission vers un transducteur de réception 66.

Le transducteur de réception 66 transforme les ondes acoustiques qu'il reçoit en un signal électrique qui est envoyé à un dispositif électronique d'analyse faisant partie du module de gestion de l'organe de dialogue.

Lorsqu'un objet appuie sur la surface de la lame de verre, il se produit un phénomène d'atténuation locale des ondes acoustiques parcourant le trajet perturbé par l'objet.

Dans le but de déterminer la position, par exemple, d'un doigt, le dispositif d'analyse est conçu pour détecter une atténuation et le trajet concerné, chaque trajet correspondant à une position sur l'axe de détection. Cette atténuation étant fonction de la force d'appui du doigt, le dispositif d'analyse détermine également cette force.

Le temps de réponse du dispositif d'analyse est suffisamment large pour être capable de suivre les mouvements du doigt.

L'utilisation de telles bandes de détection de proximité permet donc de fixer des seuils pour discriminer les actions de l'opérateur et reproduire un double fonctionnement : pour une force d'appui correspondant à un effleurement, la bande se comporte comme une tablette tactile, tandis que pour des forces d'appui franchement supérieures, la bande se comporte comme un ensemble de touches permettant d'activer des fonctions ou de valider des paramètres, la position des touches étant repérée par des étiquettes placées sous la lame de verre.

Les lames de verre 72 constituant ces bandes de détection 46,47 peuvent être facilement éclairées par la tranche à l'aide de lampes miniatures ou de diodes électroluminescentes 82 (figure 5). Les rayons lumineux 83 ainsi émis sont alors réfléchis par les étiquettes 81 portant le label des touches.

On obtient ainsi, dans un faible encombrement, un dispositif de dialogue multifonctions avec éclairage nocturne.

## Revendications

1. Terminal de communication homme/machine comprenant un écran de visualisation (9) et des moyens de commande (32 à 51) répartis à la périphérie de l'écran (9) et comprenant deux dispositifs de détection (46,47) effectuant chacun la détection sur un axe respectif, de la position d'un objet utilisé comme instrument de dialogue, les axes de ces deux dispositifs (46,47) étant perpendiculaires et disposés chacun en regard d'un bord de l'écran (9), chacun des deux dispositifs de détection (46,47) présentant un premier mode de fonctionnement permettant de localiser un objet sur son axe de détection, et un second mode de fonctionnement selon lequel son axe de détection est divisé en une pluralité de segments de commutation (13 à 20 et 21 à 31) constituant chacun une zone de commutation assimilable à une touche d'actionnement d'un interrupteur, chaque segment de commutation (13 à 20 et 21 à 31) comprenant des moyens pour déclencher le second mode de fonctionnement,
caractérisé en ce que chacun des deux dispositifs de détection (46,47) comprend des moyens de guidage de l'instrument de dialogue le long de son axe de détection, constitués par des bordures en relief s'étendant parallèlement et de part et d'autre dudit axe de détection, de manière à former une gouttière présentant un profil en U, et des moyens de centrage qui consistent en des échancrures ménagées dans les bordures et qui délimitent chacun un segment de commutation (13 à 31).

2. Terminal de communication selon la revendication 1,
caractérisé en ce que les moyens pour déclencher le second mode de fonctionnement sont activés lorsque l'instrument de dialogue exerce une pression dépassant un certain seuil sur un segment de commutation.

3. Terminal de communication selon la revendication 1 ou 2,
caractérisé en ce que chacun des segments de commutation (13 à 31) est un interrupteur constitué par au moins un élément de contact fixe (4,5) et un élément de contact mobile (6) venant s'appliquer sur l'élément de contact fixe (4,5) sous l'effet d'une pression dépassant un certain seuil, les éléments de contact (4,5,6) étant utilisés pour effectuer une détection de proximité d'un objet électriquement conducteur par effet capacitif.

4. Terminal de communication selon la revendication 3,
caractérisé en ce que la position de l'instrument de dialogue le long de l'axe de détection de chacun des deux dispositifs de détection (46,47) est déterminée par un calcul de moyenne pondérée par des coefficients représentatifs du niveau d'excitation des interrupteurs (13 à 31).

5. Terminal de communication selon l'une des revendication 1 à 4
caractérisé en ce que chacun des dispositifs de détection (46,47) est constitué par une lame de verre (72) et comprend :
- des moyens transducteurs d'émission (65) d'ondes acoustiques dans la masse de la lame de verre (72),
- des moyens (67) pour rediriger lesdites ondes acoustiques selon une multiplicité de trajets (69,70,71) de longueurs différentes respectivement associés à des position différentes de l'instrument de dialogue le long de l'axe de détection de chacun des dispositifs de détection (46,47),
- des moyens transducteurs de réception (66) des ondes acoustiques se propageant dans la lame de verre (72),
- des moyens (68) pour rediriger lesdites ondes acoustiques parcourant les multiples trajets (69,70,71) vers les moyens transducteurs de réception (66),
- des moyens pour analyser le signal issu des moyens transducteurs de réception (66), capables de détecter un amortissement d'amplitude d'onde acoustique produit par la présence d'un objet appuyant sur la lame de verre (72), et capables de déterminer lequel des multiples trajets (69,70,71) a été parcouru par l'onde acoustique dont l'amplitude a été amortie par l'objet, ledit trajet permettant de déterminer la position de l'objet le long de l'axe de détection.

6. Terminal de communication selon la revendication 5,
caractérisé en ce que les moyens pour analyser le signal issu des moyens transducteurs de réception (66) sont capables de mesurer ledit amortissement pour déterminer la pression exercée par l'objet sur la lame de verre (72), cette pression étant fonction dudit amortissement.

7. Terminal de communication selon la revendication 6,
caractérisé en ce que les moyens pour analyser le signal activent le second mode de fonctionnement lorsque la pression mesurée dépasse un certain seuil.

8. Terminal de communication selon l'une des revendications 5 à 7,
caractérisé en ce que les dispositifs de détection (46,47) comprennent des moyens d'éclairage de la lame de verre (72) par sa tranche, et des étiquettes placées sous la lame de verre (72), chaque étiquette indiquant le nom de la commande déclenchées lorsqu'une pression est exercée au dessus.

9. Terminal de communication selon l'une des revendications précédentes,
caractérisé en ce qu'il comprend des photodiodes (52 à 55) mesurant son éclairement, un dispositif d'éclairage de l'écran (9), et un module de gestion de cet éclairage capable de le contrôler en fonction de l'éclairement mesuré par les photodiodes (52 à 55).

## Patentansprüche

1. Endgerät für die Kommunikation Mensch/Maschine, mit einem Anzeigebildschirm (9) und Steuermitteln (32 bis 51), die an der Peripherie des Bildschirms (9) verteilt sind und zwei Erfassungsvorrichtungen (46, 47) enthalten, die je auf einer Achse die Position eines als Dialogwerkzeug verwendeten Gegenstands erfassen, wobei die Achsen dieser beiden Vorrichtungen (46, 47) senkrecht zueinander und je vor einem Rand des Bildschirms (9) angeordnet sind, wobei jede der beiden Erfassungsvorrichtungen (46, 47) einen ersten Betriebsmodus, der es ermöglicht, einen Gegenstand auf ihrer Erfassungsachse zu lokalisieren, und einen zweiten Betriebsmodus aufweist, bei dem ihre Erfassungsachse in eine Vielzahl von Umschaltsegmenten (13 bis 20 und 21 bis 31) aufgeteilt ist, die je eine einer Betätigungstaste eines Schalters zugeordnete Umschaltzone bilden, wobei jedes Umschaltsegment (13 bis 20 und 21 bis 31) Mittel aufweist, um den zweiten Betriebsmodus auszulösen,
dadurch gekennzeichnet, daß jede der beiden Erfassungsvorrichtungen (46, 47) Führungsmittel für das Dialogwerkzeug entlang ihrer Erfassungsachse, die aus reliefartigen Rändern bestehen, die parallel und zu beiden Seiten der Erfassungsachse verlaufen, um eine Rinne mit einem U-Profil zu bilden, und Zentriermittel aufweist, die aus in den Rändern ausgebildeten Aussparungen bestehen und die je ein Umschaltsegment (13 bis 31) begrenzen.

2. Kommunikations-Endgerät nach Anspruch 1, dadurch gekennzeichnet, daß die Mittel, um den zweiten Betriebsmodus auszulösen, aktiviert werden, wenn das Dialogwerkzeug auf ein Umschaltsegment einen Druck ausübt, der eine bestimmte Schwelle überschreitet.

3. Kommunikations-Endgerät nach Anspruch 1 oder 2, dadurch gekennzeichnet, daß jedes der Umschaltsegmente (13 bis 31) ein Schalter ist, der aus mindestens einem festen Kontaktelement (4, 5) und einem beweglichen Kontaktelement (6) besteht, das sich auf das feste Kontaktelement (4, 5) unter einem Druck auflegt, der eine bestimmte Schwelle überschreitet, wobei die Kontaktelemente (4, 5, 6) verwendet werden, um durch kapazitive Wirkung die Nähe eines elektrisch leitenden Gegenstands zu erfassen.

4. Kommunikations-Endgerät nach Anspruch 3, dadurch gekennzeichnet, daß die Position des Dialogwerkzeugs entlang der Erfassungsachse jeder der beiden Erfassungsvorrichtungen (46, 47) durch eine Berechnung des Mittelwerts bestimmt wird, der durch für den Erregungspegel der Schalter (13 bis 31) repräsentative Koeffizienten gewichtet wird.

5. Kommunikations-Endgerät nach einem der Ansprüche 1 bis 4, dadurch gekennzeichnet, daß jede der Erfassungsvorrichtungen (46, 47) aus einem Glasplättchen (72) besteht und aufweist:
- Transduktormittel (65) zum Senden akustischer Wellen in die Masse des Glasplättchens (72),
- Mittel (67), um die akustischen Wellen gemäß einer Vielzahl von Strecken (69, 70, 71) unterschiedlicher Länge umzudirigieren, die zu verschiedenen Positionen des Dialogwerkzeugs entlang der Erfassungsachse jeder der Erfassungsvorrichtungen (46, 47) gehören,
- Transduktormittel (66) zum Empfang der akustischen Wellen, die sich im Glasplättchen (72) ausbreiten,
- Mittel (68), um diese die Vielzahl von Strecken (69, 70, 71) durchlaufenden akustischen Wellen zu dem Empfangs-Transduktormitteln (66) umzudirigieren,
- Mittel, um das von den Empfangs-Transduktormitteln (66) kommenden Signal zu analysieren, die eine Dämpfung der Amplitude der akustischen Welle erfassen können, die von der Gegenwart eines Gegenstands erzeugt wird, welcher auf das Glasplättchen (72) drückt, und die bestimmen können, welche der Vielzahl von Strecken (69, 70, 71) von der akustischen Welle durchlaufen wurde, deren Amplitude vom Gegenstand gedämpft wurde, wobei die Strecke es ermöglicht, die Position des Gegenstands entlang der Erfassungsachse zu bestimmen.

6. Kommunikations-Endgerät nach Anspruch 5, dadurch gekennzeichnet, daß die Mittel, um das von den Empfangs-Transduktormitteln (66) kommende Signal zu analysieren, diese Dämpfung messen können, um den vom Gegenstand auf das Glasplättchen (72) ausgeübten Druck zu bestimmen, wobei dieser Druck von der Dämpfung abhängt.

7. Kommunikations-Endgerät nach Anspruch 6, dadurch gekennzeichnet, daß die Mittel zur Analyse des Signals den zweiten Betriebsmodus aktivieren, wenn der gemessene Druck eine bestimmte Schwelle überschreitet.

8. Kommunikations-Endgerät nach einem der Ansprüche 5 bis 7, dadurch gekennzeichnet, daß die Erfassungsvorrichtungen (46, 47) Mittel zur Beleuchtung des Glasplättchens (72) durch seine Kante und unter dem Glasplättchen (72) angeordnete Etiketten aufweisen, wobei jedes Etikett den Namen des Befehls trägt, der ausgelöst wird, wenn ein Druck darauf ausgeübt wird.

9. Kommunikations-Endgerät nach einem der vorhergehenden Ansprüche, dadurch gekennzeichnet, daß es Photodioden (52) bis 55), die seine Beleuchtung messen, eine Vorrichtung zur Beleuchtung des Bildschirms (9) und einen Modul zur Verwaltung dieser Beleuchtung aufweist, der sie in Abhängigkeit von der von den Photodioden (52 bis 55) gemessenen Beleuchtung steuern kann.

## Claims

1. A man-machine communications terminal comprising a viewing screen (9) and command means (32 to 51) distributed around the periphery of the screen (9) and comprising two detection devices (46, 47) each performing detection on a respective axis of the position of an object used as a dialog instrument, the axes of these two devices (46, 47) being perpendicular and each disposed facing an edge of the screen (9), each of said two detection devices (46, 47) having a first operating mode enabling an object to be located on its detection axis, and a second operating mode according to which its detection axis is divided into a plurality of switching segments (13 to 20 and 21 to 31) each constituting a switching zone assimilable with a switch operating key, each switching segment (13 to 20 and 21 to 31) comprising means for triggering said second operating mode, characterized in that each of said two detection devices (46, 47) has means for guiding the dialog instrument along its detection axis formed by raised edges extending parallel to and on both sides of said detection axis so as to constitute a gutter with a U-shaped profile, and centering means which consist of scallopings arranged on the edges and each delimiting a switching segment (13 to 31).

2. The communications terminal as claimed in claim 1, characterized in that the means for triggering the second operating mode is activated when the dialog instrument exerts a pressure exceeding a certain threshold on a switching segment.

3. The communications terminal as claimed in claim 1 or 2, characterized in that each of said switching segments (13 to 31) is a switch constituted by at least a fixed contact element (4, 5) and a mobile contact element (6) which is applied on the fixed contact element (4, 5) under the effect of a pressure exceeding a certain threshold, said contact elements (4, 5, 6) being used to detect the proximity of an electrically conductive object by capacitive effect.

4. The communications terminal as claimed in claim 3, characterized in that the position of the dialog instrument along the detection axis of each of said two detection devices (46, 47) is determined by computation of an average weighted by coefficients representing the level of excitation of the switches (13 to 31).

5. The communications terminal as claimed in one of claims 1 to 4, characterized in that each of the detection devices (46, 47) is constituted by a glass lamina (72) and comprises:
- a transmission transducer means (65) for acoustic waves in the mass of said glass lamina (72);
- a means (67) for redirecting said acoustic waves according to a multiplicity of paths (69, 70, 71) of different lengths respectively associated with different positions of the dialog instrument along the detection axis of each of said detection devices (46, 47),
- a reception transducer means (66) for the acoustic waves propagating in said glass lamina (72),
- a means (68) for redirecting said acoustic waves traveling along the multiple paths (69, 70, 71) towards said reception transducer means (66),
- a means for analyzing the signal supplied by the reception transducer means (66), capable of detecting a damping of acoustic wave amplitude caused by the presence of an object bearing on said glass lamina (72), and capable of determining which of the multiple paths (69, 70, 71) has been traveled by the acoustic wave whose amplitude has been damped by the object, said path enabling the position of the object to be determined along the detection axis.

6. The communications terminal as claimed in claim 5, characterized in that the means for analyzing the signal supplied by said reception transducer means (66) is capable of measuring said damping in order to determine the pressure exerted by said object on said glass lamina (72), said pressure being a function of said damping.

7. The communications terminal as claimed in claim 6, characterized in that said signal analyzing means activates the second operating mode when the pressure measured exceeds a certain threshold.

8. The communications terminal as claimed in claims 5 to 7, characterized in that the detection devices (46, 47) comprise means for lighting said glass lamina (72) by its edge and labels placed under the glass lamina (72), each label indicating the name of the command triggered when pressure is exerted thereon.

9. The communications terminal as claimed in one of the preceding claims, characterized in that it comprises photodiodes (52 to 55) measuring illumination thereof, a device for lighting said screen (9), and a management module for this lighting capable of controlling it as a function of the illumination measured by said photodiodes (52 to 55).
